(19) Europäisches Patentamt
European Patent Office
Office européen des brevets

(11) **EP 3 396 732 A1**

(12) **DEMANDE DE BREVET EUROPEEN**

(43) Date de publication:
**31.10.2018 Bulletin 2018/44**

(51) Int Cl.:
**H01L 51/52** *(2006.01)*

(21) Numéro de dépôt: **18168922.5**

(22) Date de dépôt: **24.04.2018**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **25.04.2017 FR 1753567**

(71) Demandeur: **Commissariat à l'Energie Atomique et aux Energies Alternatives**
**75015 Paris (FR)**

(72) Inventeurs:
 • BOUTAMI, Salim
  38100 GRENOBLE (FR)
 • GETIN, Stéphane
  38100 GRENOBLE (FR)
 • MAINDRON, Tony
  38000 GRENOBLE (FR)
 • RACINE, Benoit
  38690 BEVENAIS (FR)

(74) Mandataire: **Priori, Enrico**
**Marks & Clerk France**
**Immeuble "Visium"**
**22, avenue Aristide Briand**
**94117 Arcueil Cedex (FR)**

(54) **DIODE ÉLECTROLUMINESCENTE ORGANIQUE À RENDEMENT OPTIMISÉ PAR SUPPRESSION DE PLASMONS**

(57) Diode électroluminescente organique comprenant une première électrode (EL1), un empilement de couches organiques semi-conductrices (EO), comprenant au moins une couche organique électroluminescente, déposé au-dessus de ladite première électrode et une seconde électrode (EL2) déposée sur une surface dudit empilement opposée à ladite première électrode, caractérisée en ce que ladite première électrode comprend au moins une région (CP) en contact électrique avec l'empilement de couches organiques semi-conductrices entourée par une ou plusieurs régions (MB) électriquement isolées dudit empilement, ladite ou chaque dite région électriquement isolée étant structurée de manière à former au moins un miroir de Bragg adapté pour réfléchir des plasmons (PL) à une longueur d'onde λ d'émission de ladite couche électroluminescente et guidés par une interface entre ladite première électrode et ledit empilement de couches organiques semi-conductrices, ladite ou chaque dite région en contact électrique avec l'empilement formant, avec le ou les miroirs de Bragg l'entourant, une cavité ne supportant aucun mode plasmonique résonant à ladite longueur d'onde λ..

Procédé de fabrication d'une telle diode électroluminescente organique.

Fig. 2B

EP 3 396 732 A1

## Description

L'invention porte sur une diode électroluminescente organique (OLED), plus particulièrement du type à émission par le haut. Une telle diode peut être appliquée, en particulier, à l'affichage (écrans OLED) mais se prête également à d'autres applications telles que l'éclairage.

Une OLED est constituée d'un empilement de couches organiques semi-conductrices comprenant au moins une couche émissive, situé entre deux électrodes, très souvent métalliques. L'empilement organique est constitué au moins d'une couche de transport de trous, une couche d'émission (électroluminescente) et une couche de transport d'électrons. L'épaisseur de la zone organique est généralement fixée autour des 100 nm, de sorte à former une cavité Fabry-Pérot demi-onde pour le visible (l'indice optique des couches organiques est typiquement de l'ordre de 1,7). L'application d'une différence de potentiel entre les électrodes injecte dans l'empilement organique des électrons et trous qui se recombinent de manière radiative dans la couche émissive.

Les émetteurs sont à une distance assez faible des électrodes vis-à-vis de la longueur d'onde, ce qui engendre l'excitation de plasmons à la surface des électrodes, outre le mode Fabry-Pérot vertical radiatif utile. Ces plasmons sont des modes guidés planaires, totalement absorbés par le métal au bout d'une certaine distance de propagation latérale.

Le document WO 2014/191733 décrit une diode électroluminescente organique à émission par le haut (c'est-à-dire par la surface opposée à celle du substrat), dans laquelle l'électrode supérieure, à travers laquelle la lumière est émise, est structurée périodiquement de manière à former un réseau de diffraction. Le document US 2013/0153861, quant à lui, décrit une diode électroluminescente organique à émission par le bas (c'est-à-dire à travers le substrat) dans laquelle c'est l'électrode inférieure qui est structurée. Dans les deux cas, le couplage avec le réseau permet - d'une manière connue en soi - d'extraire les plasmons, améliorant ainsi le rendement radiatif.

Cette approche permet d'extraire une partie de l'énergie des plasmons, mais pas d'éliminer complètement les pertes associées à ces derniers. En outre, dans le cas d'une diode à émission par le haut (WO 2014/191733), la structuration de l'électrode supérieure risque de détériorer l'empilement organique.

L'invention vise à surmonter les inconvénients de l'art antérieur. Plus particulièrement, elle vise à procurer une diode électroluminescente organique, notamment à émission par le haut, présentant un rendement radiatif optimisé par suppression d'au moins une partie des pertes dues aux modes plasmons.

Conformément à l'invention ce but est atteint en structurant l'électrode inférieure de manière à définir des cavités planaires délimitées par des miroirs de Bragg isolés électriquement. Seules les cavités sont en contact électrique avec l'empilement organique semi-conducteur, tandis que les régions de l'électrode formant les miroirs de Bragg sont isolées. Par conséquent c'est seulement au niveau des cavités que des plasmons peuvent être excités. Les miroirs de Bragg qui délimitent les cavités sont dimensionnés de manière à présenter une réflectivité élevée à la longueur d'onde des plasmons ; ainsi ces derniers ne peuvent pas se propager et ne peuvent donc exister que sous la forme de modes stationnaires résonants, localisés dans les cavités - à la condition toutefois que la géométrie (taille et forme) de ces dernières le permette. Les cavités peuvent en particulier présenter des dimensions, rapportées à une longueur d'onde d'émission de la diode, telles qu'aucun mode stationnaire ne puisse exister à ladite longueur d'onde : l'excitation des plasmons est donc supprimée, ce qui réduit très fortement les pertes et augmente donc le rendement radiatif. La contrepartie de cette augmentation du rendement est une diminution de la surface active (c'est-à-dire susceptible d'émettre de la lumière) de l'OLED, car l'émission lumineuse ne se produit qu'en correspondance des cavités. Cela n'est cependant pas gênant pour des nombreuses applications, compte tenu du faible coût de fabrication des OLEDs et de leur très haut niveau de brillance.

Un objet de l'invention est donc une diode électroluminescente organique comprenant une première électrode, un empilement de couches organiques semi-conductrices, comprenant au moins une couche organique électroluminescente, déposé au-dessus de ladite première électrode et une seconde électrode déposée sur une surface dudit empilement opposée à ladite première électrode, caractérisée en ce que ladite première électrode comprend au moins une région en contact électrique avec l'empilement de couches organiques semi-conductrices entourée par une ou plusieurs régions électriquement isolées dudit empilement, ladite ou chaque dite région électriquement isolée étant structurée de manière à former au moins un miroir de Bragg adapté pour réfléchir des plasmons à une longueur d'onde $\lambda$ d'émission de ladite couche électroluminescente et guidés par une interface entre ladite première électrode et ledit empilement de couches organiques semi-conductrices, ladite ou chaque dite région en contact électrique avec l'empilement formant, avec le ou les miroirs de Bragg l'entourant, une cavité ne supportant aucun mode plasmonique résonant à ladite longueur d'onde $\lambda$.

Selon des modes de réalisation particuliers d'une telle diode électroluminescente organique :

- Ledit ou chaque dit miroir de Bragg peut être formé par des sillons de gravure creusés dans la surface de ladite première électrode et remplis d'un matériau diélectrique.

- Lesdites régions de la première électrode électriquement isolées de l'empilement de couches organiques semi-conductrices peuvent être recouvertes d'une couche en matériau diélectrique.

- Ledit ou chaque dit miroir de Bragg peut être une structure spatialement périodique comprenant un nombre de périodes compris entre 2 et 5.
- Ledit ou chaque dit miroir de Bragg peut être une structure spatialement périodique de période égale à $\lambda/2n_{eff}$ où $\lambda$ est une longueur d'onde d'émission de ladite couche organique électroluminescente et $n_{eff}$ un indice de réfraction effectif vu par lesdits plasmons.
- La structure spatialement périodique formant ledit ou chaque dit miroir de Bragg peut présenter un facteur de remplissage compris entre 30% et 70%, de préférence entre 40% et 60% et de manière encore préférée entre 45% et 55%.
- Ladite ou chaque dite région en contact électrique avec l'empilement de couches organiques semi-conductrices peut présenter au moins une dimension égale à

$$W = m.\frac{\lambda}{4n_{eff}} - \frac{\varphi.\lambda}{2\pi n_{eff}}$$

où $n_{eff}$ un indice de réfraction effectif vu par lesdits plasmons, $\varphi$ un déphasage introduit par le ou les miroirs de Bragg et m un entier impair strictement supérieur à 1. Plus particulièrement, la valeur de m peut être choisie parmi 3, 5 et 7.
- La diode peut comprendre également une couche ou structure multicouche diélectrique d'encapsulation déposée au-dessus de ladite seconde électrode, ainsi qu'une couche diélectrique présentant une structuration formant un réseau de diffraction déposée au-dessus de ladite couche ou structure multicouche diélectrique d'encapsulation.

Un autre objet de l'invention est un procédé de fabrication d'une telle diode électroluminescente organique comprenant :

- une étape de structuration d'une couche métallique constituant ladite première électrode, de manière à former ledit ou chaque dit miroir de Bragg;
- une étape consistant à recouvrir ledit ou chaque dit miroir de Bragg d'une couche diélectrique ; et
- une étape de dépôt dudit empilement de couches organiques semi-conductrices au-dessus de ladite première électrode, et de la seconde électrode sur une surface dudit empilement opposée à ladite première électrode.

Selon des modes de réalisations particuliers d'un tel procédé :

- Ladite étape de structuration de la première électrode peut être effectuée par gravure de sillons dans la surface de ladite électrode ; et ladite étape consistant à recouvrir ledit ou chaque dit miroir de Bragg d'une couche diélectrique peut comprendre comprend : le dépôt de ladite couche diélectrique sur toute la surface de l'électrode, de manière à combler lesdits sillons, puis une gravure sélective de ladite couche de manière à libérer au moins une région destinée à être en contact électrique avec ledit empilement de couches organiques semi-conductrices.
- Le procédé peut comprendre également, avant ladite étape de dépôt dudit empilement de couches organiques semi-conductrices et de la seconde électrode, une étape de planarisation de ladite couche diélectrique.

D'autres caractéristiques, détails et avantages de l'invention ressortiront à la lecture de la description faite en référence aux dessins annexés donnés à titre d'exemple et qui représentent, respectivement :

- la figure 1, une OLED selon l'art antérieur ;
- les figures 2A et 2B, 2C des OLEDs présentant une électrode inférieure structurée de manière à former des cavités dont la géométrie permet (2A, 2C) ou pas (2B) l'excitation de modes plasmons stationnaires ;
- les figures 3A et 3B, deux exemples de géométries planaires de cavités selon des modes de réalisation respectifs de l'invention ;
- la figure 4, un graphique du rendement radiatif d'une OLED selon un mode de réalisation de l'invention en fonction d'une dimension caractéristique d'une dite cavité ;
- la figure 5, un graphique du rendement radiatif d'une OLED selon un mode de réalisation de l'invention en fonction de la longueur d'onde ; et
- la figure 6, une OLED selon un mode de réalisation de l'invention, présentant une électrode inférieure structurée de manière à former des cavités présentant une géométrie adaptée pour empêcher l'excitation de modes plasmons stationnaires, ainsi qu'une couche diélectrique structurée permettant l'extraction des plasmons guidés par l'électrode supérieure.

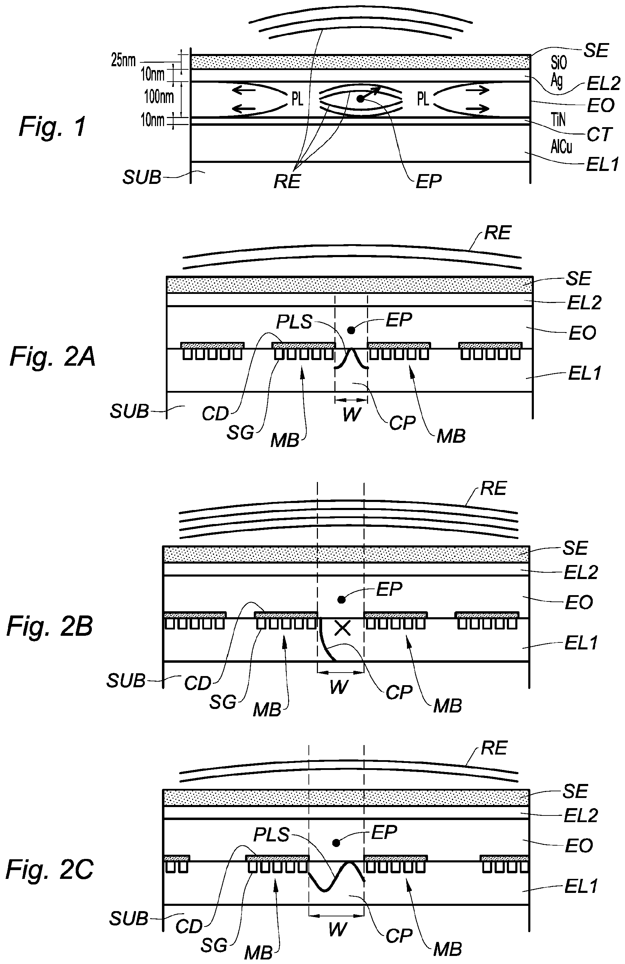

La diode électroluminescente organique de la figure 1 (qui n'est pas à l'échelle) comprend, en partant du bas :

- Un substrat SUB, qui peut être par exemple en silicium ou en verre.
- Une électrode inférieure EL1, en alliage AlCu, déposée (par exemple, par dépôt physique par phase vapeur - PVD de l'anglais « Physical Vapor Déposition ») au-dessus d'une surface du substrat. Cette électrode est opaque et peut être relativement épaisse (plusieurs centaines de nanomètres, voire quelques micromètres).
- Une couche tampon CT en TiN, présentant une épaisseur de l'ordre de 10 nm, déposée par exemple par PVD, PECVD (de l'anglais « Plasma-Enhanced Chemical Vapor Déposition », dépôt chimique en phase vapeur assisté par plasma) ou ALD (de l'anglais « Atomic Layer Déposition », dépôt de couches atomiques).

- Un empilement organique EO, d'épaisseur 100 nm, obtenue par exemple par PVD ou dépôt en phase liquide. Au centre de cet empilement se trouve une couche électroluminescente, présentant une émission centrée à la longueur d'onde de 550 nm. La figure ne montre pas cette couche, mais seulement un émetteur ponctuel (un point de la couche) EP, utilisé dans les calculs permettant l'optimisation du rendement de l'OLED. La référence RE représente le rayonnement lumineux émis par l'émetteur ponctuel et se propageant selon une direction sensiblement normale à la surface du substrat. La référence PL désigne les plasmons guidés par les interfaces entre l'empilement organique et les électrodes inférieure et supérieure. L'invention vise à empêcher l'excitation des plasmons à la surface de l'électrode supérieure, et donc à éliminer les pertes introduites par ces derniers.

- Une électrode supérieure EL2, déposée au-dessus de l'empilement organique, en Ag et ayant une épaisseur de 10 nm - suffisamment faible pour être sensiblement transparente.

- Une structure d'encapsulation SE recouvrant l'électrode supérieure afin de protéger l'empilement organique de l'oxygène atmosphérique et plus généralement de toute contamination. Dans le dispositif de la figure 1, cette structure d'encapsulation est constituée d'une couche en $SiO_x$ ($x \leq 2$), fabriquée par exemple par PVD, présentant une épaisseur de 25 nm. D'autres modes de réalisation peuvent comprendre des structures d'encapsulation multicouches, plus performantes. Par exemple, il peut être avantageux de prévoir, au-dessus de la couche en $SiO_2$, une deuxième couche en $TiO_2$ réalisée par dépôt de couches atomiques (ALD) pouvant présenter une épaisseur aussi faible que 5 nm. Une telle couche, très compacte, améliore sensiblement l'étanchéité de l'encapsulation.

L'OLED de la figure 2A se différencie de celle de la figure 1 seulement en ce que l'électrode inférieure EL1 est structurée. Plus précisément, la surface de ladite électrode en contact avec l'empilement organique EO comprend des régions structurées MB qui entourent des régions non structurées CP. Les régions structurées MB contiennent des sillons de gravure SG, d'une profondeur de quelques dizaines de nanomètres (typiquement entre 20 nm et 200 nm et de préférence de l'ordre de 100 nm, cette dernière valeur étant utilisée dans les simulations discutées ci-après), espacés régulièrement de manière à former un motif périodique et remplis d'un matériau diélectrique - typiquement une résine ou du $SiO_2$. Une couche diélectrique CD (typiquement constituée du même matériau qui remplit les sillons SG) sépare ces régions structurées MB de l'empilement organique EO ; ainsi, l'injection des porteurs ne se fait qu'en correspondance des régions non structurées CP. Sur la figure 2A, ainsi que sur les figures 2B et 2C, la couche tampon CT n'est pas représentée - on peut considérer qu'elle est confondue avec la surface de l'électrode EL1 ; au niveau des régions structurées, elle est recouverte par la couche diélectrique CD.

La périodicité L des sillons de gravure SG est choisie de manière à satisfaire la condition de Bragg pour une longueur d'onde $\lambda$ d'émission de la couche électroluminescente de l'OLED (par exemple, la longueur d'onde centrale, ou correspondante au pic d'émission), c'est à dire

$$L = \frac{\lambda}{2 \cdot n_{eff}}$$

où $n_{eff}$ est un indice de réfraction effectif pour les plasmons, dépendant essentiellement des indices de réfraction des couches organiques (généralement de valeur proche mais supérieure à celle des indices de ces couches). Préférentiellement, les largeurs des sillons et leurs espacements ont des valeurs proches de $\dfrac{\lambda}{4 \cdot n_{eff}}$, ce qui correspond à un facteur de remplissage (rapport sillons/espacement entre sillons) de l'ordre de 50%. Plus généralement, le facteur de remplissage peut être compris entre 30% et 70%, de préférence entre 40% et 60% et de manière encore préférée entre 45% et 55%.

Ainsi, ces régions MB forment des miroirs de Bragg réfléchissant les plasmons générés à l'interface entre l'empilement EO et l'électrode inférieure EL1. Ces miroirs sont d'autant plus réfléchissants que le nombre de périodes - c'est-à-dire de sillons - qu'ils comprennent est élevé ; cependant, plus ce nombre est élevé, plus petite sera la fraction active (c'est-à-dire susceptible d'injecter des porteurs dans la couche électroluminescente) de l'électrode, et donc plus faible sera la luminosité de l'OLED. Un compromis acceptable consiste à choisir des miroirs de Bragg comprenant entre 2 et 5 périodes.

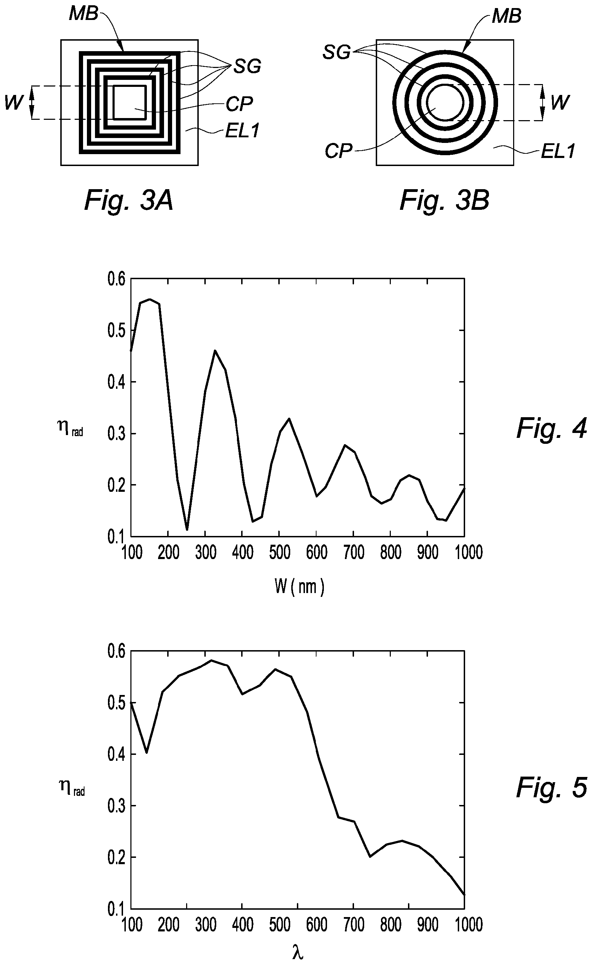

La figure 2A est une vue en coupe et ne permet pas de visualiser la configuration bidimensionnelle des régions structurées et non structurées. Les figures 3A et 3B illustrent deux configurations possibles parmi d'autres. Dans le cas de la figure 3A, les sillons de gravure suivent des tracés carrés concentriques ; dans celui de la figure 3B, ils forment des cercles concentriques. Dans les deux cas les régions structurées MB entourent complètement une région non structurée CP. Cette dernière se comporte donc comme une cavité, c'est-à-dire un résonateur, pour les plasmons.

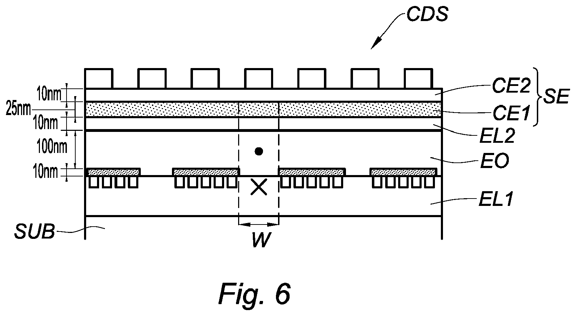

Dans les figures 2A - 2C et 6 les rapports dimensionnels entre les cavités CP et les régions structurées MB ne sont pas respectés.

Dans le dispositif de la figure 2A, la largeur W de la cavité CP (la longueur de son côté dans le cas d'une géométrie carrée - figure 3A - ou de son diamètre dans le cas d'une géométrie circulaire - figure 3B) est égale, pour une valeur de la longueur d'onde λ appartenant au spectre d'émission de la couche électroluminescente de l'OLED (par exemple, la longueur d'onde centrale, ou correspondant au pic d'émission ; de préférence, il s'agit de la même longueur d'onde utilisée pour le dimension-

$$\frac{\lambda}{2n_{eff}} - \frac{\varphi\lambda}{2\pi n_{eff}}$$

nement de la période spatiale L), à

où φ représente un déphasage introduit par les miroirs de Bragg, qui dépend de la structure ; dans la suite on prendra , à titre d'exemple non limitatif, φ=π/2 ce qui don-

$$W = \frac{\lambda}{4n_{eff}} \; .$$

ne                     Cela signifie qu'un mode plasmon stationnaire PLS (plus précisément, un mode fondamental, ou d'ordre 1) de longueur d'onde λ satisfait une condition de résonance et peut donc être excité et subsister dans la cavité. Dans ces conditions, des pertes significatives sont constatées, comme dans le cas d'une électrode non structurée.

La figure 2B se rapporte au cas où

$$W = \frac{3 \cdot \lambda}{4 \cdot n_{eff}} - \frac{\varphi\lambda}{2\pi n_{eff}} = \frac{\lambda}{2 \cdot n_{eff}}$$

(en prenant φ=π/2) pour ladite longueur d'onde λ. Dans ces conditions, aucun mode stationnaire PLS de longueur d'onde λ ne satisfait pas une condition de résonance de la cavité. L'excitation des plasmons est donc supprimée, et le rendement de l'OLED à la longueur d'onde λ augmente.

La figure 2C se rapporte au cas où

$$W = \frac{\lambda}{n_{eff}} - \frac{\varphi\lambda}{2\pi n_{eff}} = \frac{3 \cdot \lambda}{4 \cdot n_{eff}}$$

(en prenant φ=π/2). Dans ces conditions, un mode plasmon stationnaire PLS de longueur d'onde λ peut à nouveau être excité ; il s'agit alors d'un mode résonant d'ordre 2. Là encore, ce mode plasmonique introduit des pertes.

Lorsqu'on augmente ultérieurement la largeur W de la cavité, l'excitation des plasmons est à nouveau supprimée avant que le mode plasmonique d'ordre trois ne devienne résonant à son tour, et ainsi de suite. On s'attend donc à ce que le rendement radiatif, défini comme le rapport entre la puissance rayonnée $P_{rad}$ et la somme de cette même puissance rayonnée et de la puissance $P_{abs}$ absorbée par les électrodes métalliques (pertes dues essentiellement aux plasmons) :

$$\eta_{rad} = \frac{P_{rad}}{P_{rad} + P_{abs}}$$

oscille en fonction de la largeur W de la cavité. Cela est confirmé par la figure 4 qui est un graphique, obtenu par simulation numérique, du rendement radiatif de l'OLED des figures 2A - 2C, à une longueur d'onde de 550 nm, en fonction de la largeur de cavité W.

On peut vérifier que l'optimum de rendement est atteint pour W≅150 nm, ce qui est cohérent avec la théorie exposée ci-dessus, et correspond à la configuration de la figure 2B, en considérant un indice de réfraction effectif de l'ordre de 1,65, λ=550 nm et φ=π/2. Dans ces conditions optimales le rendement est d'environ 60%, alors qu'en l'absence de structuration (ce qui correspond à la limite W→ ∞) il n'atteint même pas 11 %. Lorsque W dépasse cette valeur optimale, le rendement décroît jusqu'à un minimum pour W≅250 nm, ce qui correspond à la configuration de la figure 2C. Au-delà, le rendement oscille, chaque minimum correspondant à l'apparition d'un nouveau mode de résonance de la cavité.

D'une manière générale, les maximas de rendement correspondent à des largeurs

$$W = m.\frac{\lambda}{4n_{eff}} - \frac{\varphi.\lambda}{2\pi n_{eff}}$$

avec m entier impair supérieur à 1 (m=3, 5, 7...) et les minima à des largeurs

$$W = m.\frac{\lambda}{4n_{eff}} - \frac{\varphi.\lambda}{2\pi n_{eff}}$$

avec m entier pair supérieur à 0 (m= 2, 4, 6...).

La position des minima et des maxima dépend de la phase φ, par contre leur écartement vaut toujours λ/4n_{eff}.

On remarque que les maxima et les minima sont de moins en moins prononcés au fur et à mesure que la largeur W augmente, car on tend alors vers la situation « classique » où l'électrode est continue et de dimensions grandes par rapport à la longueur d'onde. Ainsi, on utilisera de préférence m=3 ou 5, voire tout au plus 7.

Pour les très faibles valeurs de W, la théorie exposée en référence aux figures 2A - 2C n'est plus valable : la largeur de la cavité devient plus petite que l'épaisseur de l'OLED et on ne conserve plus la résonance Fabry-Pérot verticale utile. Par conséquent, le rendement s'effondre. Pour cette raison, la figure 4 ne prend pas en considération des largeurs inférieures à 100 nm.

La figure 5 illustre le rendement radiatif de la photodiode de la figure 2B (W=150 nm, correspondant au premier maximum de la figure 4). Bien que le dimensionnement soit effectué en considérant une longueur d'onde unique, λ=550 nm, on remarque que l'augmentation de rendement se produit sur une large bande. Le rendement moyen intégré sur toute la plage visible (400 - 700 nm) s'élève à 40%, ce qui est considérable. La dépendance du rendement de la longueur d'onde dépend notamment de la structure de miroir de Bragg utilisée ; en particulier, le déphasage introduit par un miroir de Bragg peut varier de manière complexe, et non nécessairement symétrique, en fonction de λ.

Une OLED selon l'invention peut être fabriquée par un procédé conventionnel, auquel s'ajoutent des étapes de structuration de l'électrode inférieure (et de la couche tampon la recouvrant) préalablement au dépôt de l'empilement organique EO.

Ces étapes comprennent la réalisation des sillons SG par gravure ionique réactive (RIE, de l'anglais « Reactive Ion Etching »), le dépôt d'une couche diélectrique qui recouvre l'électrode inférieure et remplit les sillons, puis l'enlèvement sélectif - par exemple par photogravure - ce cette couche diélectrique de manière à dégager les cavités.

De préférence, on procède ensuite à une planarisation par exemple mécano-chimique (CMP, de l'anglais « Chemical-Mechanical Planarization »). Ensuite, l'empilement EO est déposé au-dessus de l'électrode structurée de manière tout à fait conventionnelle, l'électrode supérieure est déposée au-dessus de l'empilement et la structure est encapsulée pour la protéger de l'oxygène et de l'humidité.

L'étape de planarisation n'est pas indispensable, car d'éventuelles irrégularités de la couche diélectrique CD n'affectent que des régions passives (sans injection de porteurs) de l'empilement EO.

La structuration de l'électrode inférieure, conformément à l'invention, est sans effet sur les plasmons qui se propagent à l'interface entre l'empilement EO et l'électrode supérieure, et qui contribuent aussi aux pertes. En outre, des pertes sont également provoquées par les modes optiques guidés qui restent piégés dans l'OLED. Ces pertes peuvent, en principe, être réduites en structurant l'électrode supérieure, comme enseigné par le document WO 2014/191733 précité. Toutefois, la structuration de l'électrode supérieure risque de détériorer l'empilement organique sous-jacent. Une solution plus prometteuse, illustrée par la figure 6, consiste à déposer au-dessus de la structure d'encapsulation SE une couche diélectrique CDS, par exemple en Al$_2$O$_3$ déposée par ALD, et à la structurer de manière à former un réseau de diffraction.

La couche CDS est responsable de l'extraction des plasmons et des modes guidés dans l'empilement organique ; pour cela, la période L de sa structuration est donnée par :

$$L = \frac{\lambda}{n'_{eff}}$$

où λ est une longueur d'onde de la plage spectrale d'émission de l'OLED (typiquement, la longueur d'onde centrale) et $n'_{eff}$ un indice de réfraction effectif, dont la valeur (généralement différente de $n_{eff}$) est dominée par celle de l'indice de la structure d'encapsulation. Des calculs numériques permettent de vérifier que le rendement radiatif est maximisé quand l'amplitude sommet-vallée de la structuration est de l'ordre de 100 nm ou plus et son facteur de remplissage d'environ 50% (par exemple compris entre 30% et 70% ou, de préférence, entre 40% et 60% ou de manière encore préférée entre 45% et 55%).

Avantageusement, la structuration est obtenue en gravant la couche CDS - par exemple par gravure ionique réactive - sur toute sa profondeur. Cela nécessite la présence d'une couche d'arrêt de la gravure. Dans ce but, il est avantageux d'utiliser une structure d'encapsulation plus complexe que celle considérée jusqu'ici, comprenant une première couche CE1 en SiO$_2$, par exemple de 25 nm d'épaisseur, sur laquelle est déposée une deuxième couche CE2 en TiO$_2$ de 5 nm d'épaisseur obtenue par dépôt de couches atomiques (ALD). La deuxième couche CE2 sert de couche d'arrêt pour la gravure de la couche CDS et, comme cela a déjà été évoqué plus haut, améliore l'étanchéité de l'encapsulation.

L'invention a été décrite principalement en référence au mode de réalisation de la figure 2B, mais de nombreuses variantes sont possibles.

L'empilement organique, la deuxième électrode et la structure d'encapsulation sont des éléments conventionnels et peuvent être modifiés de manière connue.

L'électrode inférieure sert généralement de cathode et l'électrode supérieure d'anode, mais l'inverse est également possible.

Les épaisseurs des différentes couches ne sont pas critiques.

L'agencement des sillons de gravure peut ne pas être parfaitement périodique, pourvu qu'il demeure suffisamment réfléchissant. Par ailleurs, les sillons ne sont qu'un exemple de structure pouvant être formée à la surface de l'électrode. Dans un autre mode de réalisation ils pourraient être remplacés, par exemple, par des surépaisseurs faisant saillie de la surface.

Les cavités peuvent présenter des formes plus complexes que celles illustrées sur les figures 3A et 3B. Ce qui compte, est qu'elles ne puissent pas supporter de mode plasmon à au moins une longueur d'onde d'émission de la couche électroluminescente de l'OLED.

**Revendications**

**1.** Diode électroluminescente organique comprenant une première électrode (EL1), un empilement de couches organiques semi-conductrices (EO), comprenant au moins une couche organique électroluminescente, déposé au-dessus de ladite première électrode et une seconde électrode (EL2) déposée sur une surface dudit empilement opposée à ladite première électrode, **caractérisée en ce que** ladite première électrode comprend au moins une région (CP) en contact électrique avec l'empilement de couches organiques semi-conductrices entourée par une ou plusieurs régions (MB) électriquement isolées dudit empilement, ladite ou chaque dite région électriquement isolée étant structurée de manière à former au moins un miroir de Bragg adapté pour réfléchir des plasmons (PL) à une longueur d'onde λ d'émission de ladite couche électroluminescente et guidés par une interface entre ladite première électrode et ledit empilement de couches organiques semi-conductrices, ladite ou chaque dite région en contact électrique avec l'empilement formant, avec le ou les miroirs de Bragg l'entourant, une cavité ne supportant aucun mode plasmonique résonant à ladite longueur d'onde λ.

2. Diode électroluminescente organique selon la revendication 1 dans lequel ledit ou chaque dit miroir de Bragg est formé par des sillons de gravure (SG), creusés dans la surface de ladite première électrode et remplis d'un matériau diélectrique.

3. Diode électroluminescente organique selon l'une des revendications précédentes dans lequel lesdites régions de la première électrode électriquement isolées de l'empilement de couches organiques semi-conductrices sont recouvertes d'une couche (CD) en matériau diélectrique.

4. Diode électroluminescente organique selon l'une des revendications précédentes dans lequel ledit ou chaque dit miroir de Bragg est une structure spatialement périodique comprenant un nombre de périodes compris entre 2 et 5.

5. Diode électroluminescente organique selon l'une des revendications précédentes dans lequel ledit ou chaque dit miroir de Bragg est une structure spatialement périodique de période égale à $\lambda/2n_{eff}$ où $\lambda$ est une longueur d'onde d'émission de ladite couche organique électroluminescente et $n_{eff}$ un indice de réfraction effectif vu par lesdits plasmons.

6. Diode électroluminescente selon la revendication 5 dans lequel la structure spatialement périodique formant ledit ou chaque dit miroir de Bragg présente un facteur de remplissage compris entre 30% et 70%, de préférence entre 40% et 60% et de manière encore préférée entre 45% et 55%.

7. Diode électroluminescente organique selon l'une des revendications précédentes dans lequel ladite ou chaque dite région en contact électrique avec l'empilement de couches organiques semi-conductrices présente au moins une dimension égale à

$$W = m.\frac{\lambda}{4n_{eff}} - \frac{\varphi.\lambda}{2\pi n_{eff}}$$ où $n_{eff}$ un indice de réfraction effectif vu par lesdits plasmons, $\varphi$ un déphasage introduit par le ou les miroirs de Bragg et m un entier impair strictement supérieur à 1.

8. Diode électroluminescente organique selon la revendication 7 dans laquelle la valeur de m est choisie parmi 3, 5 et 7.

9. Diode électroluminescente organique selon l'une des revendications précédentes comprenant également une couche ou structure multicouche diélectrique d'encapsulation (SE) déposée au-dessus de ladite seconde électrode, ainsi qu'une couche diélectrique (CDS) présentant une structuration formant un réseau de diffraction déposée au-dessus de ladite couche ou structure multicouche diélectrique d'encapsulation.

10. Procédé de fabrication d'une diode électroluminescente organique selon l'une des revendications précédentes comprenant :

   - une étape de structuration d'une couche métallique constituant ladite première électrode (EL1), de manière à former ledit ou chaque dit miroir de Bragg (MB);
   - une étape consistant à recouvrir ledit ou chaque dit miroir de Bragg d'une couche diélectrique (CD) ; et
   - une étape de dépôt dudit empilement de couches organiques semi-conductrices (EO) au-dessus de ladite première électrode, et de la seconde électrode (EL2) sur une surface dudit empilement opposée à ladite première électrode.

11. Procédé selon la revendication 10 dans lequel :

   - ladite étape de structuration de la première électrode est effectuée par gravure de sillons (SG) dans la surface de ladite électrode ;
   - ladite étape consistant à recouvrir ledit ou chaque dit miroir de Bragg d'une couche diélectrique comprend : le dépôt de ladite couche diélectrique sur toute la surface de l'électrode, de manière à combler lesdits sillons, puis une gravure sélective de ladite couche de manière à libérer au moins une région (CP) destinée à être en contact électrique avec ledit empilement de couches organiques semi-conductrices.

12. Procédé selon la revendication 11 comprenant également, avant ladite étape de dépôt dudit empilement de couches organiques semi-conductrices et de la seconde électrode, une étape de planarisation de

ladite couche diélectrique.

Fig. 1

Fig. 2A

Fig. 2B

Fig. 2C

*Fig. 3A*

*Fig. 3B*

*Fig. 4*

*Fig. 5*

*Fig. 6*

Europäisches
Patentamt

European
Patent Office

Office européen
des brevets

**RAPPORT DE RECHERCHE EUROPEENNE**

Numéro de la demande

EP 18 16 8922

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | WO 2009/136644 A1 (CANON KK [JP]; SUMIOKA YUKARI [JP]) 12 novembre 2009 (2009-11-12)<br>* page 4 *<br>* pages 8,9 *<br>* pages 17-20 *<br>* page 22; figure 9B *<br>----- | 1-12 | INV.<br>H01L51/52 |
| A | US 2011/101386 A1 (FUKUDA KOICHI [JP]) 5 mai 2011 (2011-05-05)<br>* pages 5,6; figure 1a *<br>----- | 1-12 | |
| A | WO 2008/061988 A1 (COMMISSARIAT ENERGIE ATOMIQUE [FR]; DESIERES YOHAN [FR]; GIDON PIERRE) 29 mai 2008 (2008-05-29)<br>* alinéas [0007] - [0014], [0034], [0041], [0073], [0082]; figure 1 *<br>----- | 1-12 | |
| A | US 2006/192483 A1 (NAKANISHI TSUTOMU [JP] ET AL) 31 août 2006 (2006-08-31)<br>* alinéas [0044], [0046]; figure 3 *<br>----- | 9 | |

DOMAINES TECHNIQUES RECHERCHES (IPC)

H01L

Le présent rapport a été établi pour toutes les revendications

| Lieu de la recherche | Date d'achèvement de la recherche | Examinateur |
|---|---|---|
| La Haye | 21 août 2018 | Faou, Marylène |

**EP 3 396 732 A1**

**ANNEXE AU RAPPORT DE RECHERCHE EUROPEENNE**
**RELATIF A LA DEMANDE DE BREVET EUROPEEN NO.**

EP 18 16 8922

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-08-2018

| Document brevet cité au rapport de recherche | | Date de publication | Membre(s) de la famille de brevet(s) | | Date de publication |
|---|---|---|---|---|---|
| WO 2009136644 | A1 | 12-11-2009 | JP 2009272194 A<br>US 2011006313 A1<br>WO 2009136644 A1 | | 19-11-2009<br>13-01-2011<br>12-11-2009 |
| US 2011101386 | A1 | 05-05-2011 | JP 5219745 B2<br>JP 2009140915 A<br>US 2011101386 A1 | | 26-06-2013<br>25-06-2009<br>05-05-2011 |
| WO 2008061988 | A1 | 29-05-2008 | EP 2084759 A1<br>FR 2909223 A1<br>JP 5535639 B2<br>JP 2010510637 A<br>KR 20090091706 A<br>KR 20140129347 A<br>US 2010141612 A1<br>WO 2008061988 A1 | | 05-08-2009<br>30-05-2008<br>02-07-2014<br>02-04-2010<br>28-08-2009<br>06-11-2014<br>10-06-2010<br>29-05-2008 |
| US 2006192483 | A1 | 31-08-2006 | JP 4253302 B2<br>JP 2006190573 A<br>US 2006192483 A1 | | 08-04-2009<br>20-07-2006<br>31-08-2006 |

EPO FORM P0460

Pour tout renseignement concernant cette annexe : voir Journal Officiel de l'Office européen des brevets, No.12/82

## EP 3 396 732 A1

**RÉFÉRENCES CITÉES DANS LA DESCRIPTION**

**Documents brevets cités dans la description**

- WO 2014191733 A
- US 20130153861 A